# EUROPEAN PATENT APPLICATION

(11) **EP 1 289 142 A1**
(43) Date of publication of application: **05.03.2003**
(21) Application number: 01306942.2
(22) Date of filing: 15.08.2001
(51) Int. Cl.: H03H 17/02

(54) **Digital signal filtering**

(71) Applicant: BAE SYSTEMS plc, Farnborough, Hampshire GU14 6YU (GB)
(72) Inventor: The designation of the inventor has not yet been filed
(74) Representative: Newell, William Joseph

(57) **Abstract**

A digital signal filter is described for filtering a digital signal made up of a stream of digital words, which filter comprises:-
(a) a decomposer which decomposes each word into a tuple, each tuple comprising a plurality of contiguous bits;
(c) a plurality of filters, each filter receiving all or some of the bits from a respective tuple or from a filtered tuple and applying thereto a respective filter function, and
(c) an output for concatenating said filtered tuples to provide said filtered digital signal.

## Description

This invention relates to digital signal filters and methods for digitally filtering a signal.

In particular, this invention relates to a tuple-based hybrid digital signal filter.

A variety of digital signal techniques are known for digital filtering of signals, for example to remove shot or impulse noise on analogue or digital signals. One such technique is described in our earlier published Application WO99/33175 to which reference is directed. In that earlier document, a filtering process is described whereby a number of consecutive samples in unit distance code (e.g. Gray code) are effectively stacked and supplied to respective sum and threshold devices corresponding to each bit position to determine the bulk property or a "generic result" of the consecutive samples. Such a device is referred to herein as a "neuro-filter".

In a development of this technique, described in our published International Application WO 99/33019 is a neural pattern matcher in which an array of sum and threshold devices corresponding to the bit positions in a number of exemplars effectively applies a sum and threshold operation to a number of exemplars at each bit position across the exemplar to obtain a generic result. The generic result is then correlated with the current sample at a correlation plane of EX-NOR gate and the EX-NOR results thresholded to obtain a 0 or 1 according to whether the sample is a reasonable match with the generic result. Such an architecture is referred to herein as a "neuroram" as it behaves as a neural auto-associative memory which may be programmed continually to adapt to the input data to recognise data of a particular specified class.

Although such techniques have important advantages, the filtering function is applied uniformly at all positions of the word. We have found that there are many instances where the filtering process may be considerably improved by applying different filter functions for different parts of the word to allow the filtering process to take account of the fact that different types of noise predominantly affect different bit fields of the signal. For example, shot, impulse, salt and pepper and radar noise tends to effect the most significant bits (MSB) in a weighted digital signal, whilst additive white gaussian noise seriously affects the least significant bits (LSB). Cosmic radiation induced transient single event upsets tend to affect all bits, with the greatest error being caused by changes to the most significant bits.

We have therefore designed a filter in which different filtering functions may be applied to different bit positions, or a cascade of filter functions may be applied where the filtered bits of a tuple from the original digital word may be subjected to further filtering processes.

Accordingly, in one aspect of this invention, there is provided a digital signal filter for filtering a digital signal made up of a stream of digital words, which filter comprises:-
a decomposer which decomposes each word into a plurality of tuples, each tuple comprising a plurality of contiguous bits;
a plurality of filters, each filter receiving all or some of the bits from a respective tuple or from a filtered tuple, and applying thereto a respective filter function, and
an output for concatenating said filtered tuples to provide said filtered digital signal.

By this arrangement each digital word is decomposed into tuples which may be overlapping (i.e. share common bits with a neighbouring tuple) or non-overlapping. Each of the plurality of filters receives either an input tuple or a tuple filtered in a previous filtering stage or plane.

The decomposer may be passive in the sense of merely being the hardwired circuit segregating the bits of the word into tuples as required.

Preferably, at least some of the tuples are encoded before being filtered, and are decoded after filtration. The encoding is preferred to enhance its resilience to corruption and to assist the filtration process. Suitable forms of coding are unit Hamming distance codes as described, for example, in H Walcher, "Position sensing - angle and distance measurement for engineers", Butterworth-Heinemann Ltd.,pp.111-142, 1994, or R.W. Hamming "Error detecting and error correcting codes", The Bell System Technical Journal, Vol.26, No.2, U.S.A pp.147-160, April 1950. Suitable codes include the Gray code (as described in U.S. Patent 2632058), thermometer code as discussed in J.R.Armstrong, "A RAM based methodology for the implementation of fuzzy thermacode", Proceedings of the Third International Workshop on Weightless Neural Networks" WNNW99, University of York paper No. 8 March 30 - 31, 1999.

It should be noted that each tuple may be differently encoded and that some tuples may not require encoding dependent on signal type and noise characteristic.

In many instances, the digital signal filter will be used to apply a digital filtering process to an analogue signal and so the digital filter preferably includes an analogue to digital converter for converting an analogue input signal into said digital signal, and a digital to analogue converter for converting said filtered digital signal into an analogue signal.

In one arrangement, at least one tuple passes unfiltered to the output for concatenation with the remainder of said tuples.

In some arrangements, the filter may include one or more further decomposers for decomposing one or more of said filtered tuples into sub-tuples, with said sub-tuples passing to a respective filter.

A wide range of filtering techniques may be implemented by the filters, including, but not limited to, traditional techniques such as averaging, median, Sobel, Minkowski, etc and more recent techniques such as the neuroram and neuro-filters described above. Furthermore the digital filter apparatus described above may be used to apply a mixture of traditional and novel techniques within an integrated filter structure.

In another aspect, this invention provides a method of filtering a digital signal made up of a stream of digital words, which method comprises:-
decomposing each word into a plurality of tuples, each tuple comprising a plurality of contiguous bits;
applying a plurality of respective filter functions to all or some of the bits from a respective tuple or from a filtered tuple, and
concatenating said filtered tuples to provide said filtered digital signal.

Whilst the invention has been described above it extends to any inventive combination of the features set out above or in the following description.

The invention may be formed in various ways and embodiments thereof will now be described by way of example only, reference being made to the accompanying drawings, in which:-
Figure 1 is a block diagram of a digital signal filter in accordance with this invention:-
Figure 2 is an example showing two different types of filter operation applied to a 3-tuple and a 5-tuple making up an 8 bit word;
Figure 3 is a block diagram of a second embodiment of digital signal filter in accordance with this invention illustrating pass through of the least significant bit tuple and cascaded filtering of overlapping sub tuples from the most significant bit tuple;
Figure 4 is a reference image;
Figure 5 is the image of Figure 4 but with noise added;
Figure 6 is the image of Figure 5 having been filtered with a digital filter in accordance with this invention.

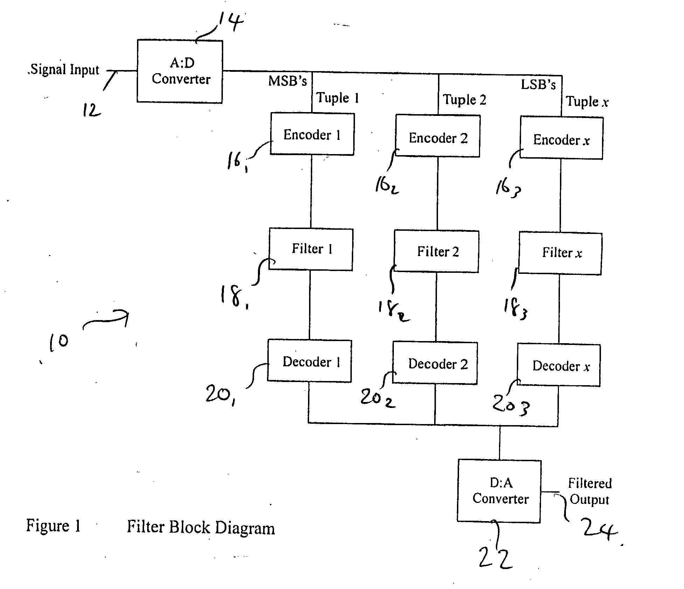

Referring initially to Figure 1, the illustrated embodiment of the digital signal filter 10 receives a 1-D 2-D or 3-D at the signal input 12 where it is quantised into n weighted digital bits by an analogue to digital converter 14. The eight bit digital signal stream is then decomposed into, in this embodiment, the 3 tuples identified as "tuple 1", "tuple 2" and "tuple x". Each tuple comprises several contiguous bits. Each tuple is encoded by an encoder 16₁, 16₂ and 16₃ using a suitable unit Hamming distance code such as a Gray code, but the coding does not need to be the same. After encoding, each tuple passes to a respective filter 18₁, 18₂ and 18₃ where a filter function is applied.

After filtering, the filter tuples are decoded at decoders 20₁, 20₂ and 20₃. The filtered and decoded tuples are then concatenated and then converted back to analogue by a digital to analogue converter 22 to provide an output at 24.

As previously mentioned, the filters may, and typically will, apply different filter functions. In particular embodiments the filter functions may change during processing.

As noted above, the tuples may be overlapping or non overlapping and several possible examples of filtered configurations are given below:-
1. 9 sample weak median filter in one bank, and a 5 sample strong median filter in another;
2. 3 sample averaging filter in one bank and 5 sample strong median filter in another;
3. 5 sample strong median filter in one bank and 7 sample neuro-filter in another;
4. 5 sample Type II neuro-filter with correlation in one bank and a 3 sample Type I neuro-filter in another.

The term "Type I neuro-filter" is used to describe a neuroram filter without a final correlation stage and the term "Type II neuro-filter" is used to describe a neuroram filter with a final correlation stage.

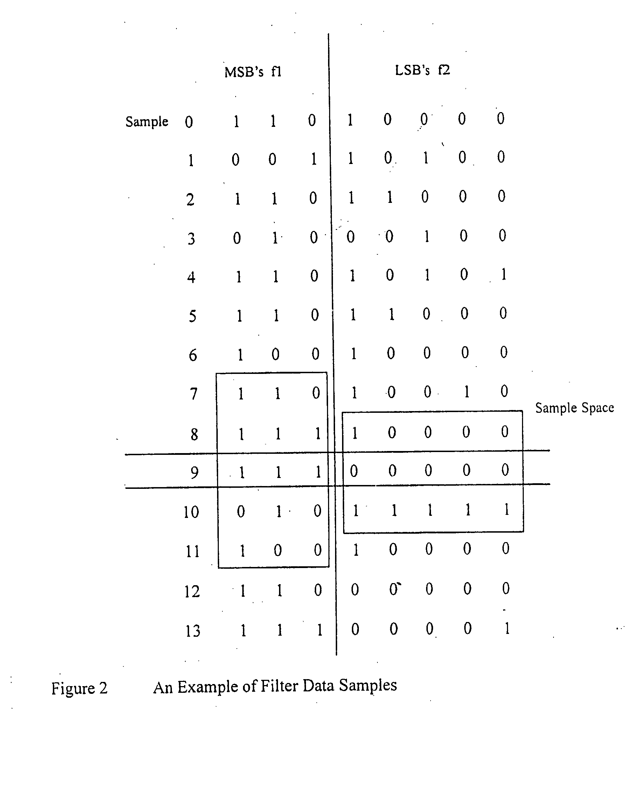

Referring now to Figure 2, there is shown an example of filter data samples being operated on by an embodiment of digital filter apparatus in which the 8 bit word is decomposed into 2 non-overlapping tuples with the 3 MSB's in one tuple and the 5 LSB's in another tuple. The 3 bit tuple is operated on by a 5 sample Type I neuro-filter and the 5 bit tuple is operated on by a 3 sample Type I neuro-filter. In this instance the 5 sample Type I neuro-filter has a threshold of 3 such that the output at a particular bit position will only be "1" if there are at least 4 1's at the corresponding bit position in the 5 samples. The threshold for the 3 sample Type 1 neuro-filter is set at 1, so that there must be at least 2 1's in the sample window at that bit position for the output to be 1 at that output bit position.

In the arrangement of Figure 2, the 5 sample and 3 sample windows are both centred on the same sample (sample 9), and the filtered result is [11010000]. In the illustration of Figure 2, sample 10 represents a noise sample, and the filter operates to replace the noise sample 10 by a filtered result of [11010000].

In the embodiment of Figure 2, the sample spaces of the filters operating on the 2 tuples are centred on sample 9. However, in certain deciphering/descrambling systems, it may be advantageous to have the tuple sample centres displaced (for example the 3 bit 5 sample neuro filter could be centred on sample 8 whilst the 5 bit tuple 3 sample filter could be centred on sample 7).

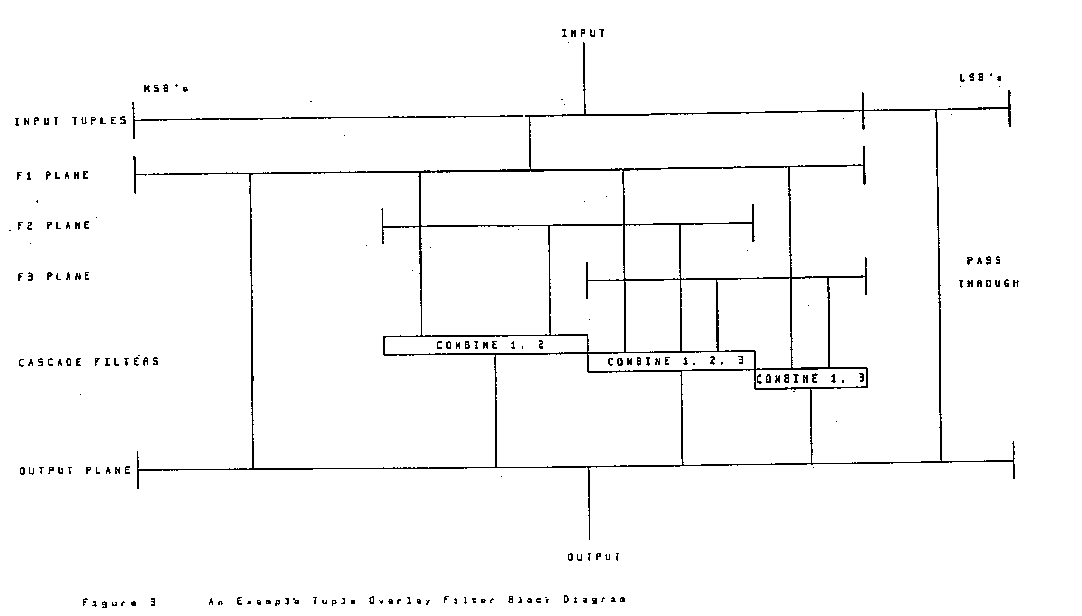

In another embodiment, illustrated in Figure 3, an input signal is decomposed at the input plane into two tuples, the MSB tuple in this instance being much wider than the LSB tuple, with the LSB tuple passing straight through to the output. The MSB tuple is subjected to a first filtering process (F1) at an F1 plane, with an MSB portion passing straight through to the output plane. A sub-tuple of the filtered tuple at the F1 plane is subjected to a further filtering operation at an F2 plane. A further sub-tuple is subjected to filtering at an F3 plane and then a series of three cascade filters. A first cascade filter combines the results of the F1 and F2 filtering operations to provide a first output tuple; the results of the filtering of the F1, F2 and F3 planes are combined by a further cascade filter, and the results of the filtering of the F1 and F3 planes are combined by a third cascade filter, with the tuples then being concatenated to provide the output.

The embodiments described above may be used in a variety of applications as follows:-
1. Filtering 1-D, 2-D and 3-D signal structures corrupted by noise sources of multiple characteristics;
2. Enhancing the robustness of signal processing systems: for example providing resilience to cosmic radiation and induced transient single event upsets;
3. Pattern matching, correlation and recognition systems;
4. Pre-processing for digital processing systems; for example pre-processing for neural associative memory sub-systems in uncertain reasoning architectures;
5. Secure communication systems.

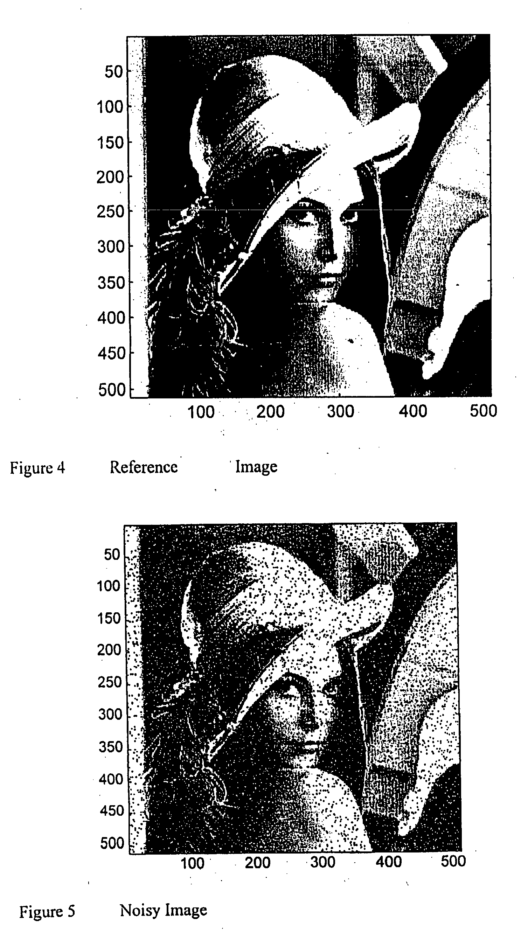

A simulation example will now be given, reference being made to Figures 4 to 6.

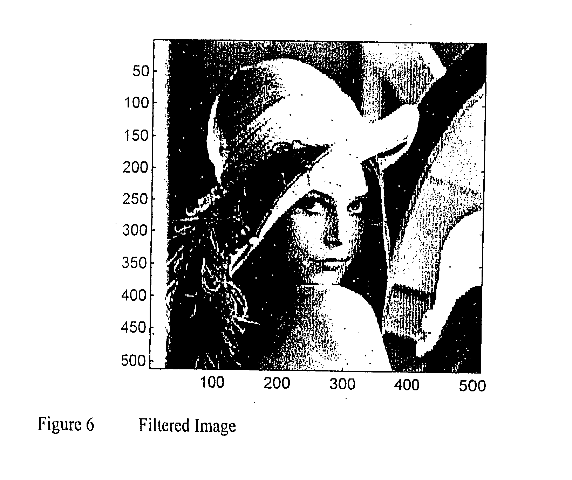

A 2D image of 512 by 512, *n* = 8 bit Gray scale pixels was used. A first filter F1 was chosen to be a 9 sample weak median filter using a tuple comprising the 4 MSB's, and a filter F2 was chosen to be a 9 sample weightless Type 1 neuro-filter using a tuple comprising the 4 LSB's. Figure 4 is a reference image and Figure 5 is the noisy image. In the noisy image, the mean square error is 2120.8 and the peak signal to noise ratio is 14.87 dB. The filtered image is shown in Figure 6; the mean square error has been reduced to 115.7 and the peak signal to noise ratio has been increased to 27.5 dB.

## Claims

1. A digital signal filter for filtering a digital signal made up of a stream of digital words, which filter comprises:-
(a) a decomposer which decomposes each word into a tuple, each tuple comprising a plurality of contiguous bits;
(b) a plurality of filters, each filter receiving all or some of the bits from a respective tuple or from a filtered tuple and applying thereto a respective filter function, and
(c) an output for concatenating said filtered tuples to provide said filtered digital signal.

2. A digital signal filter according to Claim 1 wherein at least some of said tuples are encoded before being filtered and decoded after filtration.

3. A digital signal filter according to Claim 2 wherein said digital words are in weighted binary and said encoding means uses a unit Hamming Distance code.

4. A digital signal filter according to any of the preceding claims, which includes an analogue to digital converter for converting an analogue input signal into said digital signal, and which further includes a digital to analogue converter for converting said filtered digital signal into an analogue output signal.

5. A digital signal filter according to any of the preceding claims wherein said decomposer decomposes each of said digital words into a plurality of non-overlapping tuples.

6. A digital signal filter according to any of Claims 1 to 4, wherein said decomposer decomposes each of said words into a plurality of tuples in which at least some of said plurality overlap.

7. A digital signal filter according to any of the preceding claims wherein at least one tuple is passed without filtering to the output for concatenation with the remainder of said tuples.

8. A digital signal filter according to any of the preceding claims, which includes one or more further decomposers for decomposing one or more of said filtered tuples into sub tuples, with said sub tuples passing to a respective filter.

9. A method of filtering a digital signal made up of a stream of digital words, which method comprises:-
decomposing each word into a plurality of tuples, each tuple comprising a plurality of contiguous bits;
applying a plurality of respective filter functions to all or some of the bits from a respective tuple or from a filtered tuple, and
concatenating said filtered tuples to provide said filtered digital signal.

10. A digital filter substantially as hereinbefore described with reference to and as illustrated in any of the accompanying drawings.

11. A method substantially as hereinbefore described with reference to the accompanying drawings.
